# FASCICULE DE BREVET EUROPEEN

(11) **EP 2 984 203 B1**
(45) Date de publication et mention de la délivrance du brevet: **07.08.2019**
(21) Numéro de dépôt: 14721913.3
(22) Date de dépôt: 09.04.2014
(51) Int. Cl.: C23C 14/48, C23C 14/50, H01J 37/32

(54) **MACHINE D'IMPLANTATION IONIQUE PRESENTANT UNE PRODUCTIVITE ACCRUE**
IONENIMPLANTIERUNGSMASCHINE MIT ERHÖHTER PRODUKTIVITÄT
ION-IMPLANTATION MACHINE HAVING INCREASED PRODUCTIVITY

(30) Priorité: 11.04.2013 FR 1300845
(43) Date de publication de la demande: 17.02.2016
(73) Titulaire: Ion Beam Services, 13790 Peynier (FR)
(72) Inventeur: TORREGROSA, Frank, 13109 Simiane (FR); ROUX, Laurent, 13013 Marseille (FR)
(74) Mandataire: Prugneau, Philippe
(86) Numéro de dépôt international: PCT/FR2014/000079
(87) Numéro de publication internationale: WO 2014/167193

(56) Documents cités:
- EP-A2- 0 165 618
- WO-A2-2010/033713
- US-A1- 2006 121 704

## Description

La présente invention concerne une machine d'implantation ionique présentant une productivité accrue.

Le domaine de l'invention est celui des machines d'implantation ionique qui mettent en oeuvre un plasma, autrement dit des implanteurs ioniques opérant en mode immersion plasma.

Ainsi, l'implantation ionique d'un substrat consiste à l'immerger dans un plasma et à le polariser en tension négative, de quelques dizaines de Volts à quelques dizaines de kilovolts (généralement moins de 100 kV), ceci de façon à créer un champ électrique capable d'accélérer les ions du plasma vers le substrat.

La profondeur de pénétration des ions est déterminée par leur énergie d'accélération. Elle dépend d'une part de la tension appliquée au substrat et d'autre part de la nature respective des ions et du substrat.

Le substrat ou les substrats, s'il y en a plusieurs, reposent sur un porte-substrat qui se présente comme un plateau.

Ce plateau est agencé dans une enceinte qui est raccordée à un dispositif de pompage.

La surface totale des substrats est limitée par celle du plateau qui est elle-même limitée par la taille de l'enceinte.

EP 0 165 618 présente un système de déposition RF où plusieurs substrats sont placés en parallèle entre des électrodes.

US 2006/0121704 présente un système d'implantation ionique conventionnel sur un substrat.

La présente invention a ainsi pour objet d'accroître la productivité d'une machine d'implantation ionique, autrement dit d'augmenter la surface totale des substrats que cette machine peut traiter.

Selon l'invention, une machine d'implantation ionique comprend :
- une enceinte qui est raccordée à un dispositif de pompage,
- une source plasma,
- une alimentation de polarisation,
- une entrée de gaz disposée sur cette enceinte,
- un porte-substrat raccordé au pôle négatif de cette alimentation de polarisation et agencé dans l'enceinte ;
machine remarquable en ce que :
- le porte-substrat consiste en deux plaques parallèles au moins,
- une électrode de référence consiste en une lame au moins, cette électrode de référence étant raccordée au pôle positif de l'alimentation de polarisation,
- cette lame étant intercalée entre les deux plaques.

Du fait que le porte-substrat comporte au moins deux plaques au lieu d'un seul plateau comme dans l'état de l'art, on multiplie sensiblement par deux la surface des substrats traités.

Avantageusement, le porte-substrat comporte plus de deux plaques, ces plaques étant assemblées à leurs bases sur un socle.

Suivant cet agencement, on augmente encore considérablement le nombre de substrats implantés.

De préférence, l'électrode de référence consiste en une pluralité de lames assemblées à leurs bases sur un support, les lames étant chacune intercalée entre deux plaques consécutives.

Suivant un premier mode de réalisation, la source plasma est constituée par le porte-substrat et le support, une tension de décharge étant appliquée entre ces deux éléments.

Suivant un deuxième mode de réalisation, la source plasma est une antenne radiofréquence qui ceint l'enceinte au niveau du porte-substrat, cette antenne étant raccordée à un générateur radiofréquence.

Suivant un troisième mode de réalisation, la source plasma est agencée autour de l'enceinte entre l'entrée de gaz et le porte-substrat, cette source plasma étant alimentée par un générateur.

Il est souhaitable que la machine d'implantation ionique comporte des bobines magnétiques agencées à l'extérieur de l'enceinte autour du porte-substrat.

Dans ce cas, l'allumage du plasma se trouve facilité.

Eventuellement, la machine d'implantation ionique comporte un moyen de chauffage du porte-substrat.

Il est ainsi possible de réaliser l'implantation à chaud, ce qui favorise la reconstruction des défauts et/ou l'activation des dopants in situ.

Suivant une première option, le porte-substrat est raccordé à la masse.

Suivant une seconde option, l'électrode de référence est raccordée à la masse.

L'agencement de la machine d'implantation ionique est préférentiellement tel que les plaques sont soit horizontales soit verticales.

La présente invention apparaîtra maintenant avec plus de détails dans le cadre de la description qui suit d'exemples de réalisation donnés à titre illustratif en se référant aux figures jointes parmi lesquelles :
- la figure 1 représente un schéma en coupe d'une machine d'implantation ionique comportant deux plaques,
- la figure 2 représente un schéma en coupe d'un porte-substrat électrostatique,
- la figure 3 représente un schéma en coupe d'un premier mode de réalisation d'une machine d'implantation ionique tubulaire,
- la figure 4 représente un schéma en coupe d'un deuxième mode de réalisation d'une machine d'implantation ionique tubulaire,
- la figure 5 représente un schéma en coupe d'un troisième mode de réalisation d'une machine d'implantation ionique tubulaire, et
- la figure 6 représente un schéma en coupe d'une variante de cette machine d'implantation ionique.

Les éléments présents sur plusieurs figures sont affectés d'une seule et même référence.

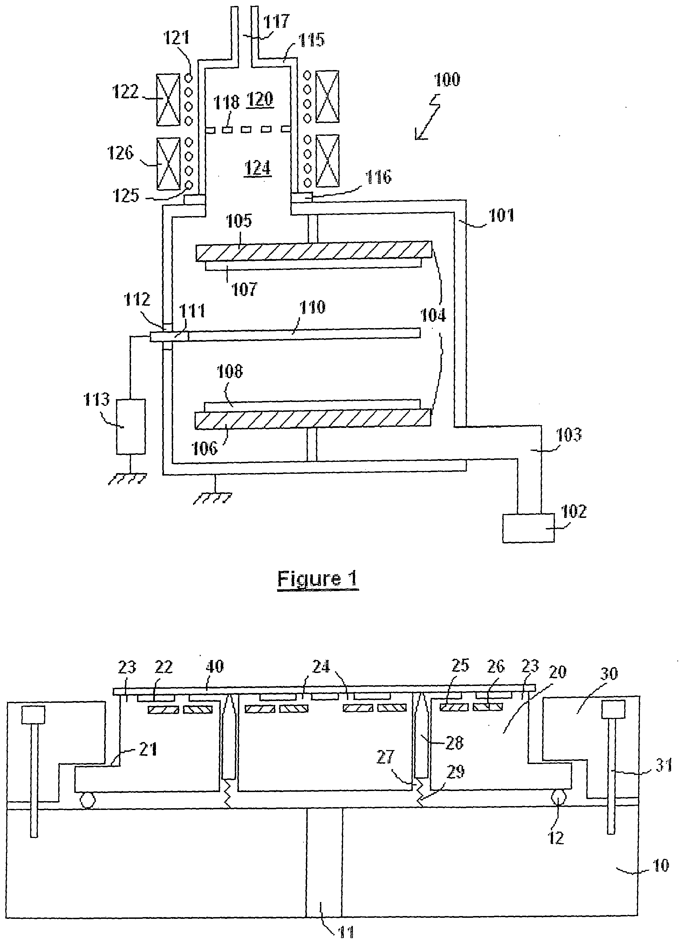

En référence à la figure 1, la machine d'implantation ionique 100 est constituée autour d'une enceinte à vide 101. Pour les applications microélectroniques, il est préconisé d'utiliser une enceinte en alliage d'aluminium si l'on souhaite limiter la contamination en éléments métalliques tel que fer, chrome, nickel ou cobalt. Un revêtement en silicium ou en carbure de silicium peut aussi être utilisé.

Des moyens de pompage 102 sont raccordés par une canalisation 103 à la partie inférieure de l'enceinte 101.

Le porte-substrat 104 est constitué par une première 105 et une seconde 106 plaques horizontales, parallèles et agencées en vis-à-vis. La première plaque 105 est assujettie au sommet de l'enceinte 101 et elle reçoit un premier substrat 107 sur sa face inférieure. La seconde plaque 106 est assujettie à la base de l'enceinte 101 et elle reçoit un second substrat 108 sur sa face supérieure. Les deux plaques 105, 106 sont électriquement conductrices et elles sont électriquement connectées à l'enceinte 101 qui est à la masse.

Une lame 110 électriquement conductrice joue le rôle d'électrode de référence. Elle présente une géométrie pratiquement identique à celle des plaques 105, 106 et elle est agencée entre ces plaques, sensiblement parallèle à ces dernières. Elle se prolonge par un pied 111 qui traverse l'enceinte 101 au moyen d'un passage haute tension 112. Ce passage haute tension 112 assure l'étanchéité, l'isolation électrique et la tenue mécanique de la lame 110.

Une alimentation électrique haute tension 113, alimentation de polarisation, voit son pôle négatif raccordé à la masse et son pôle positif raccordé au pied 111 de la lame 110. Le potentiel positif appliqué à la lame 110 est généralement compris entre quelques dizaines de volts et quelques dizaines de kilovolts. Avantageusement, la tension appliquée sera pulsée pour réduire l'extension de la gaine plasma à une dimension inférieure à la distance de séparation entre le porte-substrat et l'électrode de référence.

Classiquement, cette alimentation 113 peut consister en un simple générateur de tension continue dont le pôle négatif est raccordé à la masse. Cependant, l'invention s'applique quel que soit le moyen d'appliquer une polarisation négative au porte-substrat dans le cadre de l'implantation en mode immersion plasma, que cette polarisation soit constante ou variable. En effet, les substrats 107, 108, en particulier s'ils sont isolants, tendent à se charger positivement.

La source plasma 115 est rapportée sur la partie supérieure de l'enceinte 101. Cette source 115 se présente comme un corps cylindroïde qui s'étend entre une section initiale (en haut sur la figure) et une section terminale (en bas sur la figure). Une bride de raccordement 116 permet de fixer la section terminale de la source plasma 115 sur l'enceinte 101. La section initiale est munie d'une entrée de gaz 117 pour l'alimentation du plasma.

La source plasma est de préférence en silice fondue ou en alumine pour limiter les problèmes de contamination.

Une cloison 118 percée d'une pluralité de trous débouchants, en silice fondue de préférence, est agencée entre la section initiale et la section terminale de cette source 115, ceci pour créer une perte de charge.

A titre d'exemple, pour un corps cylindrique ayant un diamètre de l'ordre de 15 cm, les trous de la cloison 118 ont un diamètre de l'ordre de quelques mm. Pour faciliter les opérations de maintenance, la cloison 118 peut être démontable.

L'espace délimité par cette cloison 118 et la section initiale définit une chambre principale 120. Cette chambre principale 120 est extérieurement entourée par une première cellule d'ionisation qui comporte, d'une part une première antenne radiofréquence 121 et, accessoirement, d'autre part une première bobine de confinement 122. Cette antenne 121 est ici constituée par quelques spires d'un conducteur électrique, un tube ou une lame de cuivre par exemple.

Il est bien sûr possible d'utiliser tout type de source plasma : décharge, ICP (pour « Inductively Coupled Plasma » en anglais), hélicon, micro-ondes, arc.

La perte de charge entre le corps de la source plasma 115 et l'enceinte 101 permet d'établir une différence de pression entre ces deux éléments qui soit comprise entre un et deux ordres de grandeur.

L'espace délimité par cette cloison 118 et la section terminale définit une chambre auxiliaire 124.

Optionnellement, cette chambre auxiliaire 124 est elle aussi extérieurement entourée d'une deuxième cellule d'ionisation qui comporte d'une part une deuxième antenne radiofréquence 125, et d'autre part une deuxième bobine de confinement 126.

On pourrait également prévoir une seule bobine de confinement et une seule antenne recouvrant les deux chambres 120, 124 de la source plasma 115.

Les substrats 107, 108 sont maintenus sur le porte-substrat 104 par tout moyen connu de l'homme du métier, avec de la colle conductrice ou de la graisse conductrice par exemple ou par pinçage mécanique. Le second substrat 108 peut même être maintenu par gravité sur la seconde plaque 106.

Alternativement, en référence à la figure 2, on peut employer un porte-substrat électrostatique. Le montage correspondant comprend essentiellement trois parties :
- une table polarisée 10,
- un porte-substrat 20, et
- une bride de serrage 30.

La table 10 qui est polarisée à la haute tension (continue ou pulsée) se présente comme un plateau conducteur muni d'un conduit 11 qui débouche sur ses deux faces. La fonction de ce conduit 11 est détaillée plus loin.

Le porte-substrat isolant 20 repose sur la table 10 par l'intermédiaire d'un joint 12 agencé à la périphérie de la face inférieure de ce porte-substrat. Il se présente comme un cylindre qui s'appuie sur sa face supérieure, ce cylindre étant muni d'un épaulement 21 qui fait saillie à sa base.

La bride de serrage 30 permet de serrer le porte-substrat 20 sur la table 10 en prenant appui sur l'épaulement 21, ceci au moyen d'une pluralité de vis 31.

La face supérieure 22 du porte-substrat 20 présente un anneau 23 à sa périphérie et elle présente aussi une pluralité de plots 24 répartis à l'intérieur de cet anneau. L'épaisseur de l'anneau 23 et celle des plots 24 sont identiques et elle vaut typiquement 10 à 15 µm. Les sommets de l'anneau 23 et des plots 24 définissent ainsi un plan d'appui sur lequel repose le substrat 40.

Un premier type d'électrodes est utilisé pour le serrage électrostatique du substrat. Ces électrodes sont réparties par paires. Elles sont disposées dans un plan parallèle à la face supérieure 22, plan qui est très voisin de cette face supérieure. Elles sont réalisées par tout moyen connu de l'homme de l'art, par exemple en recourant à la technologie dite « couche épaisse ».

La paire qui se trouve à droite sur la figure comporte une électrode positive 25 ou anode et une électrode négative 26 ou cathode. Le principe consiste à réaliser un double condensateur :
- un condensateur anode-substrat
- un condensateur substrat-cathode.

Par ailleurs, il convient d'assurer le contact électrique entre le substrat 40 et la table polarisée 10 et cela se fait au moyen d'un deuxième type d'électrodes.

A cet effet, plusieurs canaux traversent le porte-substrat 20 de part en part. Le canal 27 qui est à droite sur la figure reçoit une pointe 28 montée sur un ressort 29 qui prend appui sur la table 10 et qui presse donc la pointe 28 contre le substrat 40. Le couple pointe-ressort constitue une électrode du deuxième type et on prévoit un tel couple dans chaque canal.

Le conduit 11 ménagé dans la table sert à emplir d'hélium le premier espace qui figure entre la face inférieure du porte-substrat 20 et cette table.

Le deuxième espace compris entre la face supérieure 22 du porte-substrat 20 et le substrat 40 est également comblé d'hélium du fait des canaux. On peut même prévoir une ouverture supplémentaire (non représentée) qui traverse le porte-substrat pour faire communiquer le premier et le deuxième espace.

Les moyens propres à la manipulation du substrat sont omis car ils sont connus de l'homme du métier.

L'invention permet ainsi de doubler le nombre de substrats par référence à l'état de l'art. Elle permet aussi d'augmenter encore significativement ce nombre.

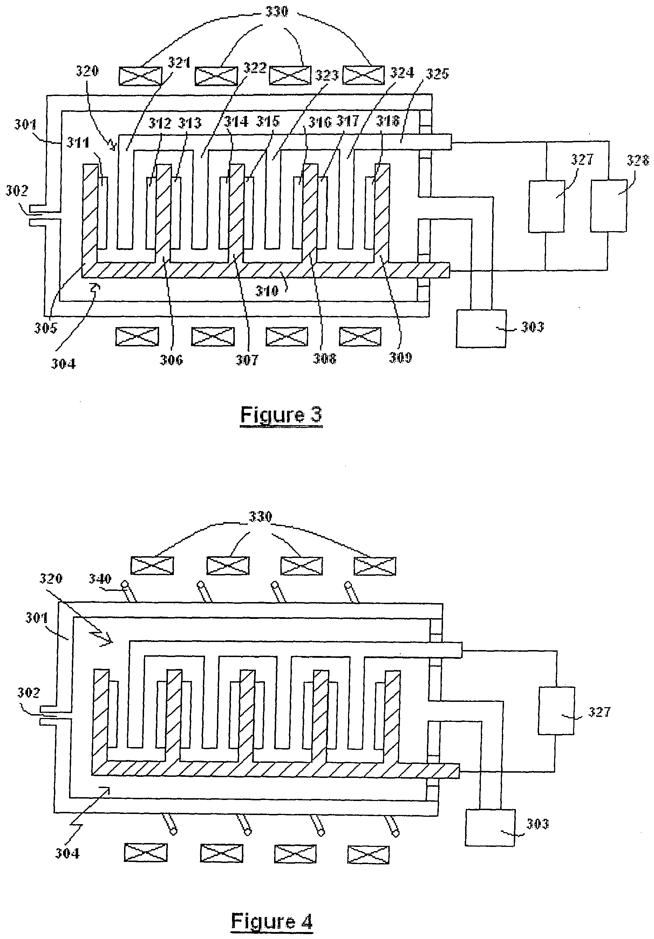

En référence à la figure 3, suivant un premier mode de réalisation, l'enceinte 301 se présente maintenant comme un tube horizontal muni d'une entrée de gaz 302 sur sa partie gauche et de moyens de pompage 303 sur sa partie droite.

Le porte-substrat 304 comporte une pluralité de plaques identiques verticales, cinq plaques 305, 306, 307, 308, 309 dans le cas présent. Ces plaques sont parallèles et elles sont disposées de sorte que leurs projections, selon un axe qui leur est perpendiculaire, soient sensiblement identiques. Ces plaques sont solidaires à leurs bases inférieures d'un socle 310 horizontal.

La première plaque 305 (à gauche sur la figure) reçoit un premier substrat 311 sur sa face droite.

La deuxième plaque 306 (à droite de la première plaque 305) reçoit un deuxième substrat 312 sur sa face gauche et un troisième substrat sur sa face droite.

La troisième plaque 307 (à droite de la deuxième plaque 306) reçoit un quatrième substrat 314 sur sa face gauche et un cinquième substrat 315 sur sa face droite.

La quatrième plaque 308 (à droite de la troisième plaque 307) reçoit un sixième substrat 316 sur sa face gauche et un septième substrat 317 sur sa face droite.

La cinquième plaque 309 (à droite de la quatrième plaque 308) reçoit un huitième substrat 318 sur sa face droite.

L'électrode de référence 320 comporte une pluralité de lames identiques verticales elles aussi, quatre lames 321, 322, 323, 324 dans le cas présent. Ces lames sont parallèles et elles sont disposées de sorte que leurs projections selon un axe qui leur est perpendiculaire soient sensiblement identiques. Ces lames sont solidaires à leurs bases supérieures d'un support 325 horizontal. Chacune desdites lames 321, 322, 323, 324 est intercalée entre deux plaques consécutives : la première lame 321 figure entre la première 305 et la deuxième 306 plaque, le deuxième lame 322 figure entre le deuxième 306 et le troisième 307 plaque, et ainsi de suite.

Le socle 310 et le support 325 débouchent tous deux à l'extérieur de l'enceinte 301 au moyen de passages haute tension. Ils sont raccordés d'une part à une alimentation électrique haute tension 327 de sorte que le socle soit polarisé négativement. Ils sont ainsi raccordés à une alimentation à décharge 328 qui est utilisée pour l'amorçage du plasma.

Accessoirement, des bobines magnétiques 330 sont agencées autour de l'enceinte au niveau du support pour confiner le plasma.

En référence à la figure 4, suivant un deuxième mode de réalisation, l'enceinte est identique à celle décrite ci-dessus en référence à la figure 3. L'alimentation à décharge est supprimée et elle est maintenant remplacée par une antenne radiofréquence 340 qui entoure l'enceinte 301 au niveau du porte-substrat 304. Cette antenne 340 est raccordée à un générateur (non représenté). Ici encore, on peut prévoir des bobines de confinement 330 qui sont agencées autour de l'antenne radiofréquence 340. Naturellement, l'enceinte doit être transparente au champ radiofréquence produit par l'antenne ; elle sera par exemple en silice fondue ou en alumine.

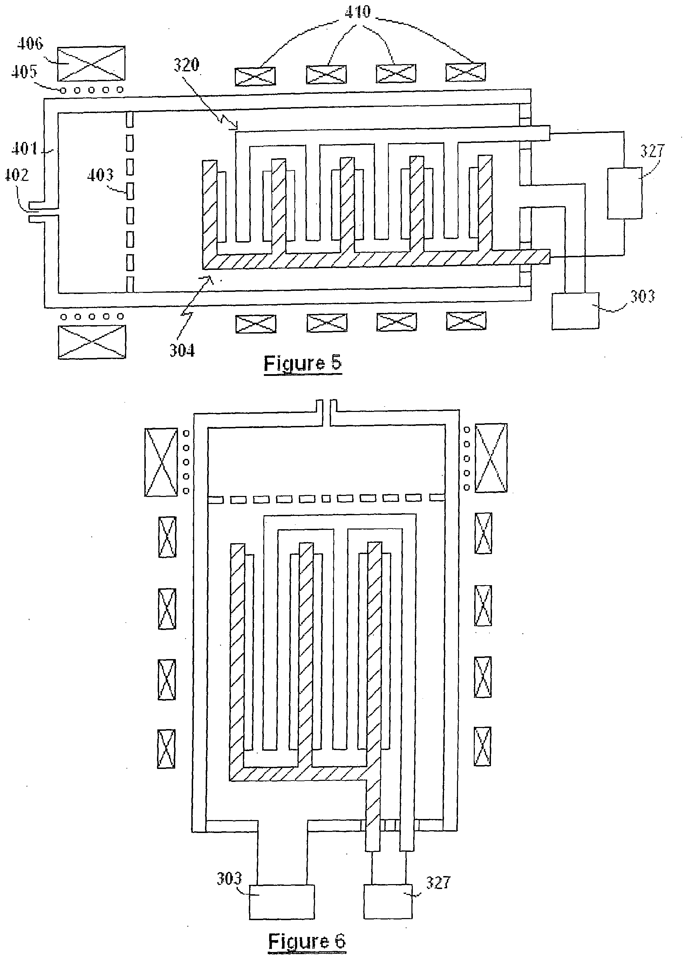

En référence à la figure 5, suivant un troisième mode de réalisation, la source plasma est maintenant déportée autour de l'enceinte 401 dans un espace libre qui figure entre l'entrée de gaz 402 et le porte-substrat 304.

La source plasma est analogue à celle décrite en référence à la figure 1 si ce n'est que maintenant elle fait partie intégrante de l'enceinte 401. On prévoit donc ici également une cloison 403 percée de trous débouchants, cette cloison sensiblement verticale figurant entre l'entrée de gaz 402 et le porte-substrat 304.

L'espace présent entre l'entrée de gaz 404 et la cloison 403 définit dont une chambre principale.

Cette chambre principale est extérieurement entourée par une cellule d'ionisation qui comporte, d'une part une antenne radiofréquence 405 et, accessoirement, d'autre part une bobine de confinement 406.

Là encore, on peut prévoir un autre ensemble de bobines de confinement 410 qui entoure l'enceinte 401 au niveau du porte-substrat 304. On améliore ainsi l'homogénéité du plasma.

L'invention permet également de réaliser une implantation à haute température. L'enceinte 401 ayant une forme de tube, il est possible d'ajouter un chauffage externe par résistances chauffantes (non représentées) qui entourent ce tube. On peut donc réaliser des implantations ioniques à chaud afin de favoriser la reconstruction des défauts et/ou d'activer les dopants in situ et/ou de contrôler la présence de dépôts parasites (notamment dans le cas d'utilisation d'hydrures comme B₂H₆, AsH₃ ou PH₃). La température de chauffe est mesurée par un thermocouple et elle sert de consigne à un asservissement du courant d'alimentation des résistances.

Pour ce qui concerne la polarisation du porte-substrat, trois configurations sont disponibles :
- l'alimentation haute tension voit son pôle positif raccordé à l'électrode de référence ainsi qu'à la masse et son pôle négatif au porte-substrat,
- l'alimentation haute tension voit son pôle négatif raccordé au porte-substrat ainsi qu'à la masse et son pôle positif raccordé à l'électrode de référence,
- l'alimentation haute tension voit son pôle négatif raccordé au porte-substrat et son pôle positif raccordé à l'électrode de référence mais aucun de ces pôles n'est raccordé à la masse.

L'alimentation haute tension peut être continue ou bien pulsée. Il est même envisageable de recourir à une polarisation haute fréquence dans la gamme des centaines de kHz.

Jusqu'à présent on a montré l'enceinte de sorte que son axe soit horizontal. On peut tout aussi bien disposer le tube verticalement. Dans ce cas, les plaques sont horizontales et les substrats qui figurent sur les faces supérieures de ces plaques n'ont pas besoin d'être fixés, ils tiennent du seul fait de la gravité.

En référence à la figure 6, suivant une variante, le tube est vertical mais les plaques et les lames sont elles aussi verticales. Les substrats sont ainsi disposés parallèlement au flux de gaz, ce qui améliore l'homogénéité de l'implantation.

Les exemples de réalisation de l'invention présentés ci-dessus ont été choisi eu égard à leur caractère concret. Il ne serait cependant pas possible de répertorier de manière exhaustive tous les modes de réalisation que recouvre cette invention. En particulier, tout moyen décrit peut être remplacé par un moyen équivalent sans sortir du cadre de la présente invention.

## Revendications

1. Machine d'implantation ionique (100) comprenant :
- une enceinte (101, 301, 401) qui est raccordée à un dispositif de pompage (102, 303),
- une source plasma (115-121-122, 304-320, 330-340, 405-406),
- une alimentation de polarisation (113, 327),
- une entrée de gaz (117, 302, 402) disposée sur cette enceinte,
- un porte-substrat (104, 304) raccordé au pôle négatif de cette alimentation de polarisation et agencé dans ladite enceinte,
**caractérisé en ce que** :
- ledit porte-substrat (104, 304) consiste en deux plaques (105-106, 305-306-307-308-309) parallèles au moins,
- une électrode de référence consiste en une lame (110, 321-322-323-324) au moins, cette électrode de référence étant raccordée au pôle positif de ladite alimentation de polarisation,
- ladite lame étant intercalée entre les deux plaques.

2. Machine d'implantation ionique selon la revendication 1, **caractérisée en ce que** ledit porte-substrat (304) comporte plus de deux plaques, ces plaques (305, 306, 307, 308, 309) étant assemblées à leurs bases sur un socle (310).

3. Machine d'implantation ionique selon la revendication 2, **caractérisée en ce que** ladite électrode de référence consiste en une pluralité de lames (321, 322, 323, 324) assemblées à leurs bases sur un support (325), lesdites lames étant chacune intercalée entre deux plaques consécutives.

4. Machine d'implantation ionique selon l'une quelconque des revendications 1 à 3, **caractérisée en ce que** ladite source plasma est constituée par ledit porte-substrat (304) et ledit support (320), une tension de décharge étant appliquée entre ces deux éléments.

5. Machine d'implantation ionique selon l'une quelconque des revendications 1 à 3, **caractérisée en ce que** ladite source plasma est une antenne radiofréquence (340) qui ceint ladite enceinte (301) au niveau dudit porte-substrat (304), cette antenne étant raccordée à un générateur radiofréquence.

6. Machine d'implantation ionique selon l'une quelconque des revendications 1 à 3, **caractérisée en ce que** ladite source plasma (405-406) est agencée autour de ladite enceinte (401) entre ladite entrée de gaz (402) et ledit porte-substrat (304), cette source plasma étant alimentée par un générateur.

7. Machine d'implantation ionique selon l'une quelconque des revendications 4 à 6, **caractérisée en ce qu'**elle comporte des bobines magnétiques (330, 410) agencées à l'extérieur de ladite enceinte (301, 401) autour dudit porte-substrat (304).

8. Machine d'implantation ionique selon l'une quelconque des revendications 4 à 7, **caractérisée en ce qu'**elle comporte un moyen de chauffage dudit porte-substrat (304).

9. Machine d'implantation ionique selon l'une quelconque des revendications précédentes, **caractérisée en ce que** ledit porte-substrat (304) est raccordé à la masse.

10. Machine d'implantation ionique selon l'une quelconque des revendications 1 à 8, **caractérisée** en que ladite électrode de référence (110, 320) est raccordée à la masse.

11. Machine d'implantation ionique selon l'une quelconque des revendications précédentes, **caractérisée en ce que** lesdites plaques (105-106, 305-306-307-308-309) sont horizontales.

12. Machine d'implantation ionique selon l'une quelconque des revendications 1 à 10, **caractérisée en ce que** lesdites plaques (105-106, 305-306-307-308-309) sont verticales.

## Patentansprüche

1. Maschine zur Ionenimplantation (100), die enthält:
- ein Gehäuse (101, 301, 401), das an eine Pumpeinrichtung (102, 303) angeschlossen ist,
- eine Plasmaquelle (115-121-122, 304-320, 330-340, 405-406),
- eine Vorspannungsversorgung (113, 327),
- einen Gaseingang (117, 302, 402), der auf diesem Gehäuse angeordnet ist,
- einen Substratträger (104, 304), der an den negativen Pol dieser Vorspannungsversorgung angeschlossen und im Gehäuse angeordnet ist,
**dadurch gekennzeichnet, dass**:
- der Substratträger (104, 304) aus mindestens zwei parallelen Platten (105-106, 305-306-307-308-309) besteht,
- eine Bezugselektrode aus mindestens einer Lamelle (110, 321-322-323-324) besteht, wobei diese Bezugselektrode an den positiven Pol der Vorspannungsversorgung angeschlossen ist,
- wobei die Lamelle zwischen die zwei Platten eingefügt ist.

2. Maschine zur Ionenimplantation nach Anspruch 1,
**dadurch gekennzeichnet, dass** der Substratträger (304) mehr als zwei Platten aufweist, wobei die Platten (305, 306, 307, 308, 309) an ihren Basen auf einen Sockel (310) montiert sind.

3. Maschine zur Ionenimplantation nach Anspruch 2,
**dadurch gekennzeichnet, dass** die Bezugselektrode aus einer Vielzahl von Lamellen (321, 322, 323, 324) besteht, die an ihren Basen auf einen Träger (325) montiert sind, wobei die Lamellen je zwischen zwei aufeinanderfolgenden Platten eingefügt sind.

4. Maschine zur Ionenimplantation nach einem der Ansprüche 1 bis 3, **dadurch gekennzeichnet, dass** die Plasmaquelle aus dem Substratträger (304) und dem Träger (320) besteht, wobei eine Entladespannung zwischen diesen zwei Elementen angelegt wird.

5. Maschine zur Ionenimplantation nach einem der Ansprüche 1 bis 3, **dadurch gekennzeichnet, dass** die Plasmaquelle eine Hochfrequenzantenne (340) ist, die das Gehäuse (301) im Bereich des Substratträgers (304) umgibt, wobei diese Antenne an einen Hochfrequenzgenerator angeschlossen ist.

6. Maschine zur Ionenimplantation nach einem der Ansprüche 1 bis 3, **dadurch gekennzeichnet, dass** die Plasmaquelle (405-406) um das Gehäuse (401) herum zwischen dem Gaseingang (402) und dem Substratträger (304) angeordnet ist, wobei diese Plasmaquelle von einem Generator versorgt wird.

7. Maschine zur Ionenimplantation nach einem der Ansprüche 4 bis 6, **dadurch gekennzeichnet, dass** sie Magnetspulen (330, 410) aufweist, die außerhalb des Gehäuses (301, 401) um den Substratträger (304) herum angeordnet sind.

8. Maschine zur Ionenimplantation nach einem der Ansprüche 4 bis 7, **dadurch gekennzeichnet, dass** sie eine Heizeinrichtung des Substratträgers (304) aufweist.

9. Maschine zur Ionenimplantation nach einem der vorhergehenden Ansprüche, **dadurch gekennzeichnet, dass** der Substratträger (304) geerdet ist.

10. Maschine zur Ionenimplantation nach einem der Ansprüche 1 bis 8, **dadurch gekennzeichnet, dass** die Bezugselektrode (110, 320) geerdet ist.

11. Maschine zur Ionenimplantation nach einem der vorhergehenden Ansprüche, **dadurch gekennzeichnet, dass** die Platten (105-106, 305-306-307-308-309) waagrecht sind.

12. Maschine zur Ionenimplantation nach einem der Ansprüche 1 bis 10, **dadurch gekennzeichnet, dass** die Platten (105-106, 305-306-307-308-309) senkrecht sind.

## Claims

1. Ion implantation machine (100) comprising:
- an enclosure (101, 301, 401) which is connected to a pumping device (102, 303),
- a plasma source (115-121-122, 304-320, 330-340, 405-406),
- a bias supply (113, 327),
- a gas inlet (117, 302, 402) arranged on this enclosure,
- a substrate support (104, 304) connected to the negative pole of this bias supply and arranged in said enclosure,
**characterized in that**:
- said substrate support (104, 304) consists of at least two parallel plates (105-106, 305-306-307-308-309),
- a reference electrode consists of at least one blade (110, 321-322-323-324), this reference electrode being connected to the positive pole of said bias supply,
- said blade being inserted between the two plates.

2. Ion implantation machine according to claim 1, **characterized in that** said substrate support (304) comprises more than two plates, these plates (305, 306, 307, 308, 309) being assembled at their bases on a pedestal (310).

3. Ion implantation machine according to claim 2, **characterized in that** said reference electrode consists of a plurality of blades (321, 322, 323, 324) assembled at their bases on a support (325), said blades being each interposed between two consecutive plates.

4. Ion implantation machine according to any one of claims 1 to 3, **characterized in that** said plasma source is constituted by said substrate support (304) and said support (320), a discharge voltage being applied between these two elements.

5. Ion implantation machine according to any one of claims 1 to 3, **characterized in that** said plasma source is a radiofrequency antenna (340) which surrounds said enclosure (301) at said substrate support (304), this antenna being connected to a radio frequency generator.

6. Ion implantation machine according to any one of claims 1 to 3, **characterized in that** said plasma source (405-406) is arranged around said enclosure (401) between said gas inlet (402) and said substrate support (304), this plasma source being powered by a generator.

7. Ion implantation machine according to any one of claims 4 to 6, **characterized in that** it comprises magnetic coils (330, 410) arranged outside said enclosure (301, 401) around said substrate support (304).

8. Ion implantation machine according to any one of claims 4 to 7, **characterized in that** it comprises a heating means of said substrate support (304).

9. Ion implantation machine according to any one of the preceding claims, **characterized in that** said substrate support (304) is connected to ground.

10. Ion implantation machine according to any one of claims 1 to 8, **characterized in that** said reference electrode (110, 320) is connected to ground.

11. Ion implantation machine according to any one of the preceding claims, **characterized in that** said plates (105-106, 305-306-307-308-309) are horizontal.

12. Ion implantation machine according to any one of claims 1 to 10, **characterized in that** said plates (105-106, 305-306-307-308-309) are vertical.
